(19) Europäisches Patentamt
European Patent Office
Office européen des brevets

(11) **EP 4 733 795 A1**

(12) **EUROPEAN PATENT APPLICATION**

(43) Date of publication:
**29.04.2026 Bulletin 2026/18**

(21) Application number: **24208884.7**

(22) Date of filing: **25.10.2024**

(51) International Patent Classification (IPC):
**G01R 33/565** (2006.01)    **G01R 33/561** (2006.01)

(52) Cooperative Patent Classification (CPC):
**G01R 33/5611; G01R 33/56509**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
• **Cauley, Stephen Farman**
**Winchester, 01890 (US)**

• **Huang, Yan Tu**
**Shenzhen, 518000 (CN)**
• **Nickel, Marcel Dominik**
**91074 Herzogenaurach (DE)**
• **Polak, Daniel**
**91052 Erlangen (DE)**
• **Splitthoff, Daniel Nicolas**
**91080 Uttenreuth (DE)**

(74) Representative: **Siemens Healthineers**
**Patent Attorneys**
**Postfach 22 16 34**
**80506 München (DE)**

(54) **METHOD FOR RECONSTRUCTING A MOTION-CORRECTED MAGNETIC RESONANCE IMAGE OF A SUBJECT**

(57)    The invention relates to a method for reconstructing a motion-corrected magnetic resonance image (20) of a subject. The method comprises receiving a motion trajectory comprising a series of motion states; determining similarities across the motion states and forming groups of motion states (G1, G2, G3), such that each group contains motion states that are similar to each other, and determining a single group motion state representing each group;

for each group of motion states, computing a single transformation operator and building a group-specific NuFT forward model (30), in which a mismatch between the coil sensitivity maps (24) and the magnetic resonance image (20) caused by a motion (22) of the subject during the acquisition is reduced by operating the transformation operator on the coil sensitivity maps (24) and/or on the magnetic resonance image; and reconstructing (46) the motion-corrected magnetic resonance image by minimizing the data consistency error between the received k-space data and the group-specific NuFT forward models, wherein each NuFT forward model comprises the image, the coil sensitivity maps, a non-uniform Fourier Transformation (30), and a phase factor corresponding to the motion state held by the subject at the time of acquiring the corresponding subset of k-space data.

FIG 6

EP 4 733 795 A1

**Description**

The invention relates to a method for reconstructing a motion-corrected magnetic resonance image of a subject, to a magnetic resonance imaging apparatus and to a computer program.

Independent of the grammatical term usage, individuals with male, female or other gender identities are included within the term.

Patient motion is one of the most common and costly artefacts in Magnetic Resonance Imaging (MRI) and can seriously degrade the diagnostic quality of magnetic resonance (MR) exams.

Fast imaging protocols reduce the impact of motion. For example, parallel imaging techniques, as summarised in J. Hamilton, D. Franson, and N. Seiberlich "Recent Advances in Parallel Imaging for MRI," Prog. Nucl. Magn. Reson. Spectrosc., vol. 101, pp. 71-95, 2017, exploit the properties of modern multi-channel coil arrays to separate aliased pixels in the image domain or to estimate missing k-space data, using knowledge of nearby acquired k-space points, in order to allow scan time reduction by sampling a smaller number of phase encoding lines in k-space.

Some magnetic resonance imaging (MRI) motion correction techniques involve measuring the motion by tracking devices or navigator acquisitions.

By contrast, retrospective methods correct for motion artefacts after the data acquisition without disruptions to the sequence timing or inclusion of additional hardware. By including motion parameters into the MR forward model, these techniques account for the patient's motion in the final image reconstruction and therefore reduce motion artefacts. In some techniques, the motion data can be derived from the acquired k-space data itself. For multi-shot acquisitions, the goal in retrospective motion correction techniques is to extract the *per shot* motion parameters and the motion-free image simultaneously. This can be accomplished by either minimizing an image quality metric, such as image entropy, or by minimizing the data consistency error of a parallel "imaging + motion" forward model, as described in L. Cordero-Grande, E. J. Hughes, J. Hutter, A. N. Price, and J. V Hajnal, "Three-dimensional motion corrected sensitivity encoding reconstruction for multi-shot multi-slice MRI: Application to neonatal brain imaging," Magn. Reson. Med., vol. 79, no. 3, pp. 1365-1376, 2018, L. Cordero-Grande, R. Teixeira, E. Hughes, J. Hutter, A. Price, Hajnal, "Sensitivity Encoding for Aligned Multishot Magnetic Resonance Reconstruction," IEEE Trans. Comput. Imaging, vol. 2, no. 3, pp. 266-280, 2016 and M. W. Haskell, S. F. Cauley, and L. L. Wald, "TArgeted Motion Estimation and Reduction (TAMER): Data consistency based motion mitigation for MRI using a reduced model joint optimization," IEEE Trans. Med. Imaging, vol. 37, no. 5, pp. 1253-1265, 2018. For the latter, the motion and image vector are jointly estimated via an inversion of the non-linear forward model. This corresponds to a large-scale non-linear optimization problem that is typically computationally very expensive. Previously proposed methods alternate between optimizing just the image or the motion parameters while assuming the other to be fixed (see L. Cordero-Grande in Magn. Reson. Med.), instead of updating all optimization variables at once. Nevertheless, repeated updates of the imaging voxels lead to excessive computation that prohibits its use in clinical settings.

Retrospective motion correction techniques are often based on SENSE parallel imaging, where rigid body motion operators are added to describe motion within the forward model. When the "imaging + motion" forward model and the underlying imaging protocol also include parallel imaging techniques, which make use of the complex sensitivity profiles of multi-channel coil arrays, such as SENSE (SENSitivity Encoding) or ASSET (Array coil Spatial Sensitivity Encoding), it is referred to as "SENSE + motion" model.

In "Scout accelerated motion estimation and reduction (SAMER)", Magn. Reson. Med., vol. 87, pp. 163-178, 2022, https://doi.org/10.1002/mrm.28971, D. Polak, D. N. Splitthoff, B. Clifford, W.-C. Lo, S. Huang, J. Conklin, L. L. Wald, K. Setsompop and S. Cauley propose a technique that utilizes a single rapid scout scan to drastically reduce the computational cost of motion estimation. The scout image contains centre of k-space information which is compared against the k-space data of the actual MR acquisition for each shot, to derive the subject's motion. This corresponds to registration of the k-space data with the scout image in k-space. This strategy is used to completely avoid the alternating optimization of subject motion and image volume, which is otherwise required in retrospective motion correction techniques. In the SAMER-technique, a motion trajectory of the subject is first estimated, and the motion trajectory is then used in a motion-aware parallel image reconstruction, using e.g. a "SENSE + motion" forward model, to yield the motion-mitigated image. This reduces the computational costs by several orders of magnitude, when compared to established alternating optimization methods.

In D. Polak, J. Hossbach, D. N. Splitthoff et al. "Motion guidance lines for robust data consistency-based retrospective motion correction in 2D and 3D MRI", Magn. Reson. Med. 2023:1-14, doi: 10.1002/mrm.29534, D. Polak et al. have extended the SAMER method to include the repeated acquisition of a small number of motion guidance lines in each shot, which are used for motion estimation by being compared with the data from the scout scan. This allows for very rapid and fully separable estimation of motion parameters shot-by-shot.

In SAMER as well as in other retrospective motion correction techniques, the "SENSE + motion" model often uses one motion state per shot of acquired k-space data. The reconstruction time typically scales with the number of shots, and thus can be very high in a clinical setting. It has been proposed in EP 4 187 271 A1 to cluster similar motion states and thereby process shots with similar motion parameters together, but this presents a trade-off between motion correction accuracy and computation time.

It is therefore an object of the invention to provide a method for reconstructing a motion-corrected magnetic resonance image that facilitates clinically feasible computation times, e.g. not more than about one minute. It is a further object to provide a method for reconstructing a motion-corrected magnetic resonance image with excellent correction accuracy, within clinically feasible computation times.

This object is met or exceeded by a method according to claim 1, a computer program according to claim 13, a data processing device according to claim 14 and a magnetic resonance apparatus according to claim 15. Further advantages and features can be derived from the dependent claims, the description and the attached figures.

According to a first aspect of the invention, a computer-implemented method for reconstructing a motion-corrected magnetic resonance image of a subject is provided. The method comprises:

a. receiving k-space magnetic resonance data acquired of the subject using a multi-channel coil array during a magnetic resonance imaging acquisition;

b. receiving coil sensitivity maps of the multi-channel coil array;

c. receiving a motion trajectory comprising a series of motion states which were held by the subject during the acquisition;

d. determining similarities across the motion states and forming groups of motion states, such that each group contains motion states that are similar to each other, and determining a single group motion state representing each group;

e. for each group of motion states, computing a single transformation operator and building a group-specific NuFT forward model, in which a mismatch between the coil sensitivity maps (24) and the magnetic resonance image (20) caused by a motion (20) of the subject during the acquisition is reduced by operating the transformation operator on the coil sensitivity maps (24) and/or on the magnetic resonance image (22),

f. reconstructing (46) the motion-corrected magnetic resonance image by minimizing the data consistency error between the received k-space data and the group-specific NuFT forward models, wherein each NuFT forward model comprises an image estimate, the coil sensitivity maps, a non-uniform Fourier Transformation (30), and a phase factor corresponding to the motion state held by the subject at the time of acquiring the corresponding subset of k-space data.

The subject may for example be a human person, in particular a patient, or an animal or part of a human person or animal. Accordingly, motion cannot always be avoided during MR imaging. Taking into account the motion states during image reconstruction is thus required in order to avoid image artefacts, e.g. blurred or distorted images. This is done by using a so-called motion trajectory, comprising a time series of motion states, each motion state describing a pose of the subject, which may change over time and thus also during the acquisition of the MR image. The motion states in particular comprise motion parameters such as translational and/or rotational components, for example 3 translational and 3 rotational components, if the subject undergoes mainly rigid motion. More complex (non-rigid) motion can be described according to the invention using e.g., motion vector fields. This is typically performed for liver or heart imaging as these organs do not move rigidly (as opposed to the head).

The inventive method uses a non-uniform Fourier Transform (NuFT). A non-uniform Fourier Transform is a method of performing a Fourier Transformation (FT) on a dataset in which the individual samples are spaced non-uniformly in space. This is required, for example, when data has been non-uniformly sampled in the frequency domain. NuFT is for example used in MRI when using a non-Cartesian acquisition technique. NuFT data processing techniques are disclosed for example in Fessler J, Sutton B. "Nonuniform fast Fourier transforms using min-max interpolation." IEEE Trans Signal Process 2003; 51: 560-574.

The invention is based on the insight that - if the motion trajectory of the subject is known or can be estimated e.g. from the acquired MR data - the raw k-space data from the image acquisition can be motion-corrected directly in k-space using a NuFT, in particular a non-uniform fast-Fourier Transform algorithm. The basis for this approach is that rotations in image space correspond to rotations in k-space, while image translations in image space introduce phase ramps in k-space. It is therefore possible to motion-correct the acquired data in k-space, for example to rotate the k-space samples according to the rotational parameters of the estimated motion state. However, the result is a k-space dataset with non-uniform sampling. For addressing this non-uniformity, the here-described NuFT can be used. The advantage of the NuFT approach is therefore that explicit image transformations (translations/rotations) in the spatial domain are avoided. This has computational advantages, as the motion correction forward model (e.g. "SENSE + motion") becomes independent of the number of motion states $N_s$. The reason is that the motion is corrected directly where it occurred, namely in k-space. If the motion is corrected in image space, by contrast, more iterations are required, since the image has to be rotated and shifted for each relevant motion state before going back to k space and selecting the respective frequency components.

Moreover, the invention has recognized that the NuFT approach only approximates the correct physical model, as will be explained below. This sometimes results in incorrect motion correction and therefore image artefacts. The invention proposes a novel strategy to solve these modelling issues and to retain high image quality.

In particular, the invention has recognized that, if patient motion is corrected in k-space and the acquired data is shifted to new k-space coordinates, the "shading" applied to the data by the sensitivity profiles of the receive coil-array is not correctly accounted for. Most MR examinations are performed with a receive radiofrequency (RF) coil comprising several small individual coils, also referred to as coil array. The signal detected by each of these coils is received on a different channel. Since the individual coils have different positions around the body, this effect is used as ancillary positional information in SENSE parallel imaging. However, in order to process the signal from the different channels correctly, the coil sensitivity profiles - herein referred to as coil sensitivity maps - need to be estimated, i.e. a map of the coil sensitivity within the field-of-view of the acquired image for each individual coil of the coil array. Such sensitivity profiles are estimated or measured by a pre-scan performed at the beginning of an MR imaging examination. For example, the multi-channel coil array may be an RF coil that is fixedly arranged with respect to the MR scanner during the patient examination, in particular fixed to the patient bed, for example a head coil or a spine array coil. Therefore, patient movement does not result in corresponding motion of the multi-channel coil array.

In the actual physical acquisition process, the coils stay fixed and their sensitivities stay constant (to a very good degree). Therefore, in a correct mathematical model, the sensitivity profiles need to be applied after moving the object/image in the image domain, not in k-space. The correct SENSE+motion forward model therefore applies image transformations first, and then multiplies with the coil sensitivity. The NuFT approach implicitly couples the application of these two operations. This is because, in the NuFT approach, the transformation is performed in k-space, after the sensitivity profiles have been applied. Mathematically, this means that both the image AND the sensitivities are corrected for motion, which is not fully correct.

The inventive method therefore includes a further transformation into the model used to estimate the motion-corrected image, wherein the transformation aims at reducing the "mismatch" between the coil sensitivity maps and the magnetic resonance image caused by motion, which is explained above. This is done by including a transformation operator into the model, as explained below. This can be done in several ways. In a first embodiment, the coil sensitivity maps are pre-rotated by a transformation operator. In a second embodiment, it is the image which is pre-rotated and/or pre-shifted by a transformation operator. In a further embodiment, a transformation operator is operated on both image and coil sensitivity maps. By incorporating the pre-rotated coil sensitivity maps into the NuFT model according to the first embodiment, a close-to physically correct reconstruction may be achieved. As an alternative the image can be pre-rotated and pre-shifted, which then has to be taken into account when applying the motion information during the NuFT operator.

The transformation operator may approximate the motion state, but it does not have to match it exactly. Rather, it has been recognized by the invention that it is not necessary to compute a transformation operator for each individual motion state. Rather, the motion states can be grouped together, so that similar motion states are processed using the same NuFT model. One of the reasons for this is that the coil sensitivity profiles generally vary smoothly in space. Therefore, small positional changes do not make much difference in the coil sensitivity shading, and therefore the "mismatch" between image and coil sensitivity profiles need not be corrected for very small motion, for example less than 1°. Therefore, motion states that are similar to each other can be grouped together. This is done according to the invention in a step (d) of determining similarities across the motion states and forming groups of motion states, such that each group contains motion states that are similar to each other, and determining a single group motion state representing each group. The step of determining similarities across the motion states and forming groups of motion states is also referred to as "binning"; and a group of motion states may be referred to as "bin". Preferably, the number of bins/groups is less than 10, more preferred less than 5, for one MRI image acquisition.

In order to reconstruct the motion-corrected image, the method further comprises a step (e) of, for each group of motion states, computing a single transformation operator and building a group-specific NuFT forward model, in which a mismatch between the coil sensitivity maps and the magnetic resonance image caused by a motion of the subject during the acquisition is reduced by operating the transformation operator on the coil sensitivity maps and/or on the magnetic resonance image, and a step (f) of reconstructing the motion-corrected magnetic resonance image by minimizing the data consistency error between the received k-space data and the group-specific NuFT forward models, wherein each NuFT forward model comprises an image estimate, the coil sensitivity maps, a non-uniform Fourier Transformation, and a phase factor corresponding to the motion state held by the subject at the time of acquiring the corresponding subset of k-space data. The motion-corrected image is obtained from the image estimate (also referred to herein as image) after the minimisation has been carried out.

Thus, the reconstruction using a single-pose NuFT is expanded to a multi-pose NuFT by building a NuFT forward model for each group of motion states. In this model, a mismatch between the coil sensitivity maps and the magnetic resonance image is reduced by operating the transformation operator for that group of motion states on the coil sensitivity maps and/or on the magnetic resonance image estimate. These group-specific NuFT forward models are then used to reconstruct the image. Each group-specific NuFT forward model is applied to the subsets of k-space data acquired while the subject held a motion state belonging to that group. Each group-specific NuFT forward model comprises the image estimate (in the second embodiment this means the pre-rotated image), the coil sensitivity maps (in the first embodiment this means the pre-rotated coil sensitivity maps), a non-uniform Fourier Transformation, and a phase factor corresponding to the motion state held by the subject at the time of acquiring the corresponding subset of k-space data. Thus, the k-space data is corrected using the motion trajectory received in step (c).

The single group motion state may be used to compute the transformation operator. In some embodiments, the transformation operator is based on or corresponds to the group motion state or its inverse. However, the transformation operator does not have to correspond exactly to the group motion state. Rather, the transformation operator may include any rotational and/or translational movement, as long as the mismatch between coil sensitivity maps and image is reduced to some degree, e.g. reduced by 40% or more. It does not have to be reduced to zero. One may even allow arbitrary image transformations of both the image and coil sensitivity, based on a small number of group motion states. In embodiments where the image is pre-rotated by the transformation operator, the NuFT k-space coordinates need to be adjusted to correct for the remaining/relative motion that has not been accounted for by the transformation operator. For example, each subset of k-space data is corrected/rotated by the corresponding motion state held by the subject at the time of acquiring the subset, minus the transformation operator (which has already operated on the data in image space).

In preferred embodiments, the transformation operator is computed on the basis of the group motion state. For example, it may correspond to the group motion state, or to the inverse of the group motion state.

The magnetic resonance imaging acquisition may be a two-dimensional (2D) or three-dimensional (3D) image acquisition. It may be performed by means of any type of imaging sequence, for example a gradient-echo or spin-echo type sequence. Preferably, the MRI acquisition comprises the sampling of k-space in a number of k-space lines or samples, wherein the k-space magnetic resonance data is acquired. A part of k-space data for which one motion state is available is herein referred to as "subset of k-space data". The MR image is preferably acquired from a field-of-view covering a body part of the subject, for example from the head, neck, shoulders, breast, abdomen, limbs or from an organ such as the heart, liver, lungs etc.

According to an embodiment, the imaging sequence comprises a plurality of echo trains or "shots" wherein one shot comprises a plurality of magnetic resonance echoes, e.g. spin echoes and/or gradient echoes. During each echo, a k-space line or sample is acquired. In most sequences, an echo train comprises an excitation or preparation pulse, and then all echoes have their own excitation/refocussing pulses. There may be 1 to 512 echoes, preferably 8 to 256 echoes, in one echo train. A "shot" in this context may thus refer to a subset of the k-space data, which has been acquired during a certain short time period, so that an individual motion state can be assigned to this subset of k-space data. A "shot" can be also a sub-part of an echo train; the important aspect is that a "shot" contains sequentially acquired k-space data that corresponds to one motion state. Accordingly, a "shot" may comprise the k-space data from one or several echo train(s), but may also refer to the k-space data from a part of an echo train, wherein an echo train may include several spin echoes and/or gradient echoes. One k-space line may be acquired during one echo, and there may be for example 64 to 512, preferably 128 to 256 echoes in one shot. A shot may comprise one or several k-space lines which have been acquired successively.

According to an embodiment, the method comprises

- for each group of motion states, determining the part of the k-space data that was acquired while the subject was in one of the motion states belonging to that group, and
- dividing the k-space data into bins according to their group of motion states, wherein the k-space data from each bin is processed using the group-specific NuFT forward model during the reconstruction of the motion-corrected magnetic resonance image. This allows to reduce computation time by using the FuFT approach, while at the same time accounting for the strong motion cases where the NuFT assumptions might not be valid anymore. In order to save computation time, it is preferably if the number of bins/groups of motion states is less than 15, preferably less than 10.

According to an embodiment, the non-uniform Fourier Transformation uses calculated k-space coordinates, wherein the calculated k-space coordinates are derived by transforming the original k-space coordinates of each subset of k-space data with a rotational operator corresponding to the motion state held by the subject at the time of acquiring the corresponding subset of k-space data. Thereby, the motion trajectory is taken into account during the NuFT image reconstruction in step (f). Optionally, in embodiment where the transformation operator is operated onto the magnetic resonance image, the motion states are corrected by the transformation operator, whereby the image is pre-rotated and/or pre-shifted.

According to a first embodiment, the inventive method includes a step of calculating a transformation operator, which preferably represents the motion of the group motion state, and computing inverse-rotated coil sensitivity maps by operating the inverse transformation operator on the coil sensitivity maps. This inverse-rotated coil sensitivity maps $C_j$ are incorporated in the NuFT operator. By using such inverse-rotated coil sensitivity maps, the undesired coil sensitivity profiles transformation that is introduced when using the NuFT is reversed, and the model is again physically correct, to a good degree.

For example, the inverse-rotated coil sensitivity maps are calculated according to

$$C_j = \left( R_{\theta_j} T_{\theta_j} \right)^{-1} C$$

Wherein $C$ represents the coil sensitivity maps, j is the number of the group of motion states, $\theta_j$ is the group motion state belonging to that group, $R_{\theta_j}$ is the rotation matrix belonging to the motion state $\theta_j$, $T_{\theta_j}$ is the translation vector belonging to the motion state $\theta_j$, and $C_j$ represents the inverse-rotated coil sensitivity maps. Since this calculation is done only once per group, the computational effort is reduced to a useful level.

According to a second embodiment, step (e) comprises operating the transformation operator onto the magnetic resonance image estimate, whereby the image is pre-rotated and/or pre-shifted. Again, the transformation operator may correspond to the group motion state.

For example, step (e) may comprise operating the transformation operator onto the magnetic resonance image according to

$$x_j = R_{\theta_j} T_{\theta_j} x$$

wherein $x$ is the magnetic resonance image, j is the number of the group of motion states, $\theta_j$ is the transformation operator belonging to that group, $R_{\theta_j}$ is the rotation matrix belonging to the transformation operator $\theta_j$, $T_{\theta_j}$ is the translation vector belonging to the transformation operator $\theta_j$, and $x_j$ is the pre-rotated and/or pre-shifted image for group j. The transformation operator is preferably considered when applying the motion information from the motion trajectory during the NuFT operation. In other words, $\theta_j$ is subtracted from the motion states when estimating the motion-corrected image, since $\theta_j$ has already been operated on the image.

When determining similarities across motion states, it is possible that motion states may appear repeatedly, in particular periodically, during the image acquisition, e.g. due to motion related to breathing or a heartbeat. Thus, redundancies across the motion states may arise when motion states do not change or change only minimally in between the acquisition of k-space lines or samples. Furthermore, similarities/redundancies may arise when motion states reappear periodically due to periodic movement of the subject. The inventive method thus includes a step (d) of compressing motion states. This has already been proposed in order to accelerate retrospective motion correction using a SENSE + motion model in EP 4 187 271 A1, which is incorporated herein by reference. In particular, the techniques disclosed therein for compressing the plurality of motion states are incorporated herein by reference, for example excluding redundant motion states, and/or neglecting redundant, e.g. insignificant and/or small, variations, that are determined across the motion states. The image reconstruction method disclosed in EP 4 187 271 A1 using the SENSE + motion model is also incorporated herein by reference. Using this prior art method, the reconstruction time may be decreased substantially. However, there may be a trade-off between motion correction accuracy and computation time.

The inventive method may therefore comprise a step of dividing the motion trajectory into bins based on a pre-defined clustering threshold, i.e., translational motion differing by less than 8mm, preferably less than 5mm and/or rotational motion differing by less than 8°, preferably less than 5°.

For each group/bin, a transformation operator is then determined, which may correspond approximately to the group motion state, and is incorporated into the group-specfic NuFT forward model with the aim to return to an (almost) physically correct motion model, in an embodiment by reversing the undesired coil sensitivity transformations caused by the NuFT.

The invention provides the advantages that the image quality of the standard SENSE+motion model is almost maintained. Furthermore, the reconstruction time may be up to 10 times faster than the reconstruction using the SENSE+motion model. It is almost independent of the number of motion states or shots. Therefore, the method of the invention can usefully be applied to image data with strong motion, i.e. where the patient moved often during the MR imaging acquisition.

This speed-up in acquisition time can facilitate retrospective motion correction on low-end compute systems. Alternatively, it can be leveraged to enable computationally demanding reconstructions which incorporate both motion correction and Artificial Intelligence solutions, such as Deep Learning.

The conventional SENSE+motion reconstruction typically requires binning/grouping of motion states to avoid unacceptably long reconstruction times. However, this binning provides a trade-off between reconstruction time and correction accuracy and can lead to potential image quality degradation. The NuFT reconstruction time is independent of the number of motion states and thus overcomes this important issue.

According to an embodiment, the motion trajectory is determined by using any one of

- a retrospective motion correction method,
- a motion tracking device, in particular a radiofrequency pick-up coil or an optical camera,
- a navigator method,
- an AI-based motion detection method, or
- a Pilot Tone method.

A retrospective motion correction method may for example be the SAMER techniques, or the SAMER techniques using motion guidance lines, as mentioned above. Thereby, a number of additional motion guidance lines are acquired in every shot, and are used to estimate a motion state for every shot, potentially with reference to a low-resolution scout image. Alternatively, the motion trajectory can be obtained from an additional motion tracking or sensor device, such as a RF pick-up coil, or a 2D or 3D camera which acquires optical images of the subject or patient during the MR examination, or that tracks a marker attached to the subject or patient. Further, a navigator method may be used, wherein navigator scans are taken throughout the image acquisition. Further, a pilot tone method may be used. Therein, a pilot tone RF signal is acquired from the body, which is just off-resonance form the MR signal but still within the bandwidth of the RF acquisition apparatus, and thus can be acquired with the RF receive coil. Finally, Artificial Intelligence (AI)-based motion detection methods may also be used, wherein the acquired data is analysed e.g. by a machine learning model to detect the motion.

According to an embodiment, a low-resolution magnetic resonance reference image of the subject is provided. The low-resolution image can for example be acquired before or after the image acquisition. The low-resolution image may be used in the estimation of the motion trajectory, in particular when using the SAMER method

According to an embodiment, each motion state comprises a plurality of motion parameters, in particular translational and rotational motion parameters, and wherein a group of motion states are categorized to be similar to each other if all motion parameters of any one of the group of motion states differ by no more than by a predetermined threshold value from the corresponding motion parameter of any other one of the group of motion states. Thereby, the redundancies across the motion states are determined by finding similarities between different motion states, and in particular by comparing the motion parameters of different motion states with each other and finding a redundancy if the differences are below a predetermined threshold. The predetermined threshold may for example be set to be between 1 and 8mm, preferably between 2mm and 5mm for the translational movement, and between 1° and 8°, preferably 2° and 5° for the rotational movement. The compression of the motion states may for example comprise allocating different shots corresponding to similar motion states to a single group motion state. The predetermined threshold may be a variable to adjust the level of compression. Accordingly, the threshold may be chosen to be as low as needed in order to achieve a desired accuracy, in particular with regard to a required model accuracy and/or a level of acceptable artifacts.

According to an embodiment, compressing the plurality of motion states may comprise forming groups of motion states, such that each group contains motion states that are similar to each other with respect to their motion parameters, in particular by comparing the motion parameters of different shots, preferably all shots, to each other. The similarities may be determined by using the above-described threshold. The motion states of each one group may be combined into a single group, in particular such that the number of groups/bins is lower than the number of original motion states. A new group motion state with new motion parameters may be assigned to each group. e.g. by computing the average motion across the motion states of every group. Thereby, recurring motion states, such as caused by alternating and/or periodic movement, may also be combined into a single group.

According to an embodiment, every motion parameter may comprise at least one component, preferably a plurality of components, wherein a group of motion states may be categorized to be similar to each other if all the components of the motion parameter of any one of the group of motion states differ no more than a predetermined threshold value, in particular the predetermined threshold as mentioned above, from the corresponding components of the motion parameter of any other one of the group of two motion states. The components of the motion parameter may be in particular translational and/or rotational components. Preferably, in the case of 3D image data, and assuming 3D rigid body motion, there may be three translational and/or three rotational components. For 2D image data and again assuming rigid motion, only 3 components are needed, e.g. two translational and one rotational component. In a more general embodiment, which also takes into account non-rigid motion, each motion state may be described by a motion vector field, and in this case the components of the motion parameters may be the vectors of the motion vector fields. The proposed compression techniques also work for these types of (non-rigid) motion. For example, a plurality of motion vector fields may be grouped together if all corresponding vectors of the motion vector fields differ no more than a predetermined threshold value. The grouping may be adjusted such that a reconstruction time and a model accuracy is balanced according to the requirements of the corresponding examination.

According to an embodiment, the single group motion state of each group of motion states is determined by averaging the motion parameters of all motion states in the group. Thereby, each group of motion states is represented by its mean or average motion state.

According to an embodiment, the motion trajectory comprises one motion state per shot of acquired k-space data. This allows the use of the SAMER technique for estimating a motion trajectory, and provides a useful number of motion states.

According to an embodiment, the method comprises a further step performed after step (d) of

- assessing the number of groups of motion states,
- selecting the image reconstruction process according to the number of groups of motion states to comprise either steps (e) and (f), or to comprise an image reconstruction process using the SENSE + motion model wherein the groups of motion states are combined to reduce the reconstruction time. The latter image reconstruction process may be performed according to EP 4 187 271 A1. Thus, the invention also provides a metric for determining the best image reconstruction algorithm. In particular, if the number of groups of motion states is above a certain threshold, wherein the threshold may be between 2 and 20, preferably between 4 and 8, then the NuFT according to steps (e) and (f) is performed. It has been shown that the inventive NuFT approach is particularly useful if the subject motion cannot be compressed well into bins. This is because the invention does not require iteration over the different motion states and usually only a low number of bins is required. On the other hand, if there are only very few groups of motion states, the standard SENSE+motion model with FFT and using compressed motion states may also be very fast.

According to a further aspect of the invention, a computer program comprising instructions, which, when the program is executed by a data processing device, cause the data processing device to carry out the (steps of the) method as described herein, is provided. The data processing device may for example be part of a computer, in particular personal computer, and/or a clinical computing hardware. It may in particular be part of a control computer of an MR apparatus with which the MR imaging acquisition may be carried out. All features and advantages of the method may be adapted to the computer program and vice versa.

According to a further aspect of the invention, a computer-readable medium having stored thereon the computer program as described above is provided. The computer-readable medium may in particular be a non-transitory computer-readable medium. The computer-readable medium may be any digital storage medium, such as a hard disc, a cloud, an optical medium such as a CD or DVD, a memory card such as a compact flash, memory stick, a USB-stick, multimedia stick, secure digital memory card (SD) etc. All features and advantages of the method and the computer program may be adapted to the computer-readable medium and vice versa.

According to a further aspect of the invention, a data processing device comprising means for carrying out the method as described herein is provided. The data processing device may be or may comprise a computer. The computer may be any computer comprising a sufficiently powerful processing unit, which may be a CPU or GPU, or several such processing units.

Accordingly, the computer may be a PC, a server, a console of an MRI apparatus, but it also may be a computer that is remote from the MRI apparatus, it may be connected with it through the internet. Accordingly, the computer may also be a cloud computer, a remote server etc. The computer may also be a mobile device, such as a laptop, tablet computer or mobile phone. The data processing device may further comprise an interface configured to receive k-space data, in particular multi-channel k-space data, acquired in a multi-shot imaging protocol, in particular using a multi-channel coil array. The data processing device may further or alternatively comprise a processing unit configured to carry out the computer program as described herein.

According to a further aspect of the invention, an MR apparatus comprising the data processing device is provided. All features and advantages of the method, the computer program, and the computer-readable medium may be adapted to the data processing device and vice versa.

The accompanying drawings illustrate various example methods and other example embodiments of various aspects of the invention.

Fig. 1    is a schematic representation of a magnetic resonance (MR) apparatus according to an embodiment of the invention;

Fig. 2    illustrates the steps of the SENSE + motion model;

Fig. 3    illustrates the order of steps in the SENSE + motion model versus the order of steps in the NuFT approach;

Fig. 4    is a plot of an uncompressed motion trajectory, illustrating the step of determining similarities and forming groups of motion states;

Fig. 5    is an illustration of k-space and k-space lines, which are acquired during different group motion states;

Fig. 6    is a flow diagram illustrating the steps of an embodiment of the inventive method.

Similar elements are designated with the same reference signs in the drawings.

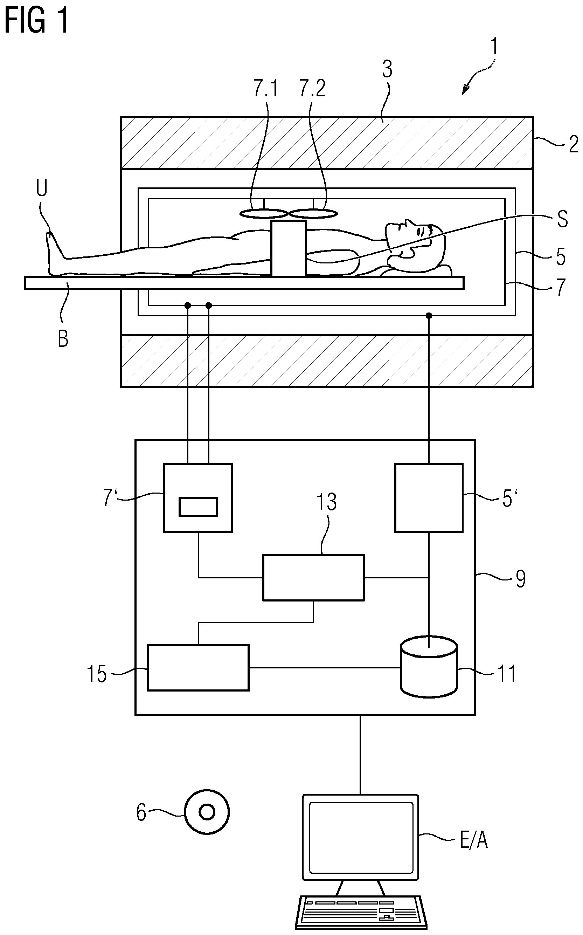

Fig. 1 schematically shows an inventive magnetic resonance (MR) apparatus 1. The MR apparatus 1 has an MR data acquisition scanner 2 with a main magnet 3 that generates the constant magnetic field B0, a gradient coil arrangement 5 that generates the gradient fields, one or several radiofrequency (RF) antennas 7 for radiating and receiving RF signals, and a control computer 9 configured to perform the inventive method. The radio-frequency antennas 7 include a multi-channel coil array comprising at least two coils, for example the schematically shown coils 7.1 and 7.2, which may be configured to transmit and/or receive RF signals (MR signals).

In order to acquire MR data from an examination subject U, for example a patient or a phantom, the subject U is introduced on a bed B into the sensitive volume or bore of the scanner 2. A 3D MR image can be acquired using a method according to an embodiment of the invention from a 3D field-of-view or slab. The control computer 9 controls the MR apparatus 1, and the gradient coil arrangement 5 with a gradient controller 5' and the RF antenna 7 with a RF transmit/receive controller 7'. The RF antenna 7 has multiple channels corresponding to the multiple coils 7.1, 7.2 of the coil arrays, in which signals can be transmitted or received. A control unit 13 of the control computer 9 is configured to execute all the controls and computation operations required for acquisitions. The control computer 9 also has a processing unit 15 which computes the motion-corrected image according to the method described herein. Intermediate results and final results determined in the process can be stored in a memory 11 of the control computer 9. A user can enter control commands and/or view displayed results, for example image data, an input/output interface E/A. A non-transitory data storage medium 6 can be loaded into the control computer 9 and may be encoded with programming instructions (program code) that cause the control computer 9, in particular the processing unit 15, to implement any or all embodiments of the method according to the invention.

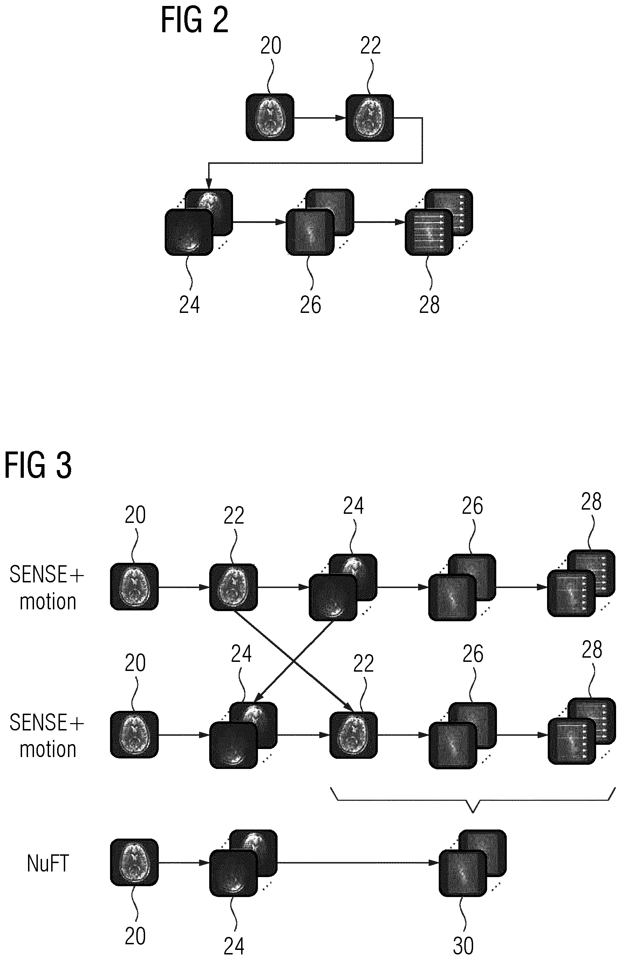

The SENSE + motion model and the NuFT approach shall now be described with reference to Figs. 2 and 3, including the mathematical description.

Retrospective motion correction is often based on SENSE+motion parallel imaging, as described in Pruessmann K.P. et al., "Advances in sensitivity encoding with arbitrary k-space trajectories". Magn Reson Med. 2001;46(4):638-651. In this model, rigid body motion operators R and T are added to describe motion within the forward model.

$$s = E_\theta x = \sum_{i=1}^{N_s} M_i F C T_{\theta_i} R_{\theta_i} x \qquad (1)$$

According to this model, the k-space data s is related to the image volume 20, x, through image motion operators 22 (rotations R and translations T), the coil sensitivity maps 24 C, the Fourier operator 26 F, an undersampling operator 28 $M$ for every shot $i$ and the sum across all shots $N_s$. In this description, it is assumed that each shot is associated with a motion state. However, this is not a prerequisite for the technique, it is possible that several shots are associated with one motion state. More generally, a part of the k-space data is associated with a single motion state.

This forward model is illustrated in Fig. 2 and is for example described in Batchelor P.G. et al. "Matrix description of general motion correction applied to multishot images". Magn Reson Med. 2005;54(5):1273-1280. doi:10.1002/mrm.20656.

The motion corrected image $\tilde{x}$ may thus be obtained by solving a standard least squares problem

$$[\tilde{x}] = \min_x \|E_\theta x - s\| \qquad (2)$$

The reconstruction time of equation 2 typically scales with the number of shots $N_s$ (Eq. 1). In this motion-corrected image reconstruction, the grouping together of motion states with similar motion parameters can reduce the reconstruction time, however, this presents a trade-off between motion correction accuracy and computation time.

The standard NuFT approach accounts for patient rotations by calculating new k-space coordinates $\hat{k}$. For every acquired k-space sample, the original sampling location $\boldsymbol{k}$ is multiplied by a 3D rotation matrix R which considers the respective motion parameters $\theta$.

$$\hat{\boldsymbol{k}} = R\boldsymbol{k} = \begin{pmatrix} R_{xx} & R_{xy} & R_{xz} \\ R_{xy} & R_{yy} & R_{yz} \\ R_{xz} & R_{yz} & R_{zz} \end{pmatrix} \begin{pmatrix} k_x \\ k_y \\ k_z \end{pmatrix} \qquad (3)$$

Translations of the object/patient only change the phase of every acquired k-space sample and are computed as following.

$$\hat{\phi}_k = T\boldsymbol{k} = \left(T_x\ T_y\ T_z\right)\begin{pmatrix}k_x\\k_y\\k_z\end{pmatrix} \tag{4}$$

The NuFT model relates the motion corrupted k-space s to the motion-free image x through the calculated k-space coordinates $\hat{k}$ and phase $\hat{\phi}_k$

$$s = \hat{E}_\theta x = \exp\left(i\hat{\phi}_k\right) \mathrm{NuFT}_{\hat{k}} Cx \tag{5}$$

The motion corrected image is again obtained by solving a least squares problem, however, without having to loop across all motion states $N_s$ (Eq. 5). This often provides computational speed-up over Eq. 2.

However, a caveat of this technique is that it reverses the order of applying image transformations (rotations/translations) and coil sensitivity shading. This is illustrated in Fig. 3. The top row of Fig. 3 shows the SENSE+motion model with the physically correct order of applying motion and coil shading to the image x (20), namely first the motion operator 22, then the coil sensitivity maps C, 24, then the Fourier operator F, 26, and finally the sampling mask 28. In the row below, these two operations have been reversed. The NuFT reconstruction is illustrated in the bottom row of Fig. 3. It corresponds to the same reversed, physically in-correct order which can lead to residual artifacts. Reversing the order implies that the coil (typically fixed to the patient table) moves along with the object/patient, which is physically incorrect.

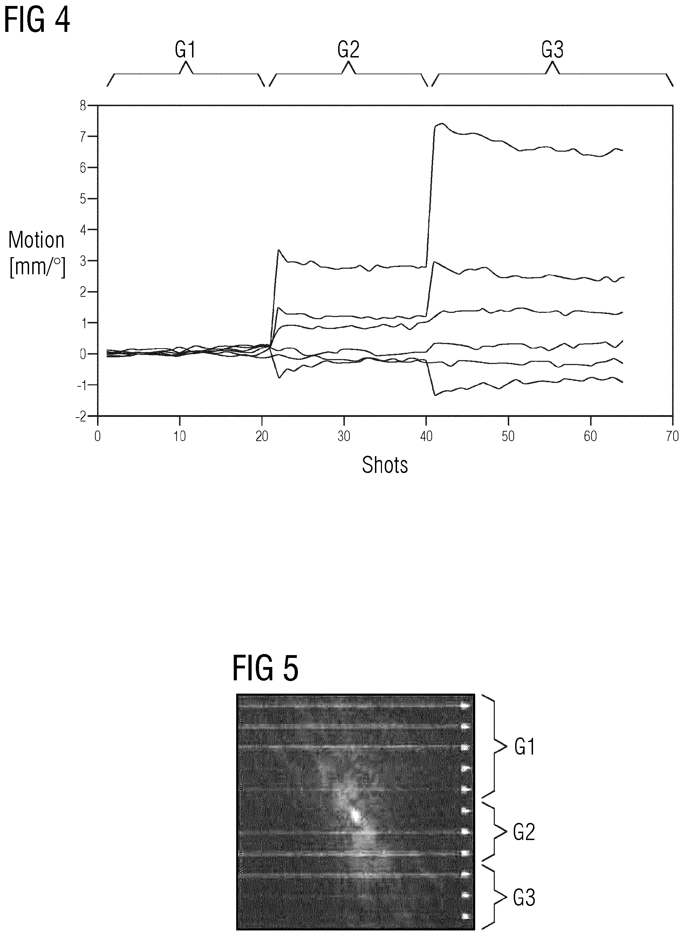

To overcome this modelling issue, according to an embodiment of the invention, a multi-pose NuFT reconstruction (MP NuFT) is proposed, which is illustrated in Figs. 4 to 6.

As illustrated in Fig. 4, the motion trajectory $\theta$ is clustered into $N_j$ bins based on similarities across the motion states/shots. Fig. 4 shows 64 motion states corresponding to 64 shots (the horizontal axis) and their motion parameters (the vertical axis). The vertical axis shows the motion parameters in mm in the case of translational motion components and in degree (°) in the case of rotational motion components. The different lines represent the different components of the motion parameters. One can see that some motion states are similar to each other. Therefore, the motion states are clustered/grouped into three group motion states G1, G2 and G3 based on their similarity and a predetermined threshold of e.g. 4 mm or degrees for each component of the motion parameters. Thus, the motion states where each translational and rotational motion parameter does not differ from each other by more than 4mm or 4° are grouped together. Accordingly, the first ca. 20 shots are grouped together into the group or bin G1, the second ca. 20 shots are grouped together into the group or bin G2, and the third ca. 24 shots are grouped together into the group or bin G3. Thus, every group motion state describes the pose of the subject during a number of shots.

Fig. 5 shows an illustration of a 2D k-space, with the acquired k-space lines/samples grouped into the different bins G1, G2 and G3.

According to an embodiment of the inventive method the acquired k-space samples s and NuFT k-space coordinates $\hat{k}$ are then divided into the $N_j$ bins, i.e., $s = (s_1, s_2, ..., s_{N_j})^T$, $\hat{k} = (\hat{k}_1, \hat{k}_2, ... , \hat{k}_{N_j})^T$.

According to a first embodiment of the invention, "pre-rotated", herein referred to a as "inverse-rotated", coil sensitivity maps

$$C_j = \left(R_{\theta_j} T_{\theta_j}\right)^{-1} C \tag{6}$$

are computed for every bin j using the inverse (affine) transformation $(R_{\theta_j} T_{\theta_j})^{-1}$ and the motion parameters $\theta_j$. As an alternative, the image can be pre-rotated in the opposite direction; this step then needs to be accounted for when applying the coordinate correction as part of the NuFT. The main idea of this "inverse-rotated" coil sensitivity $C_j$ is to undo/reverse the undesired coil transformation that is introduced when using the NuFT and thus return to an (almost) physically correct motion model. According to an embodiment, $\theta_j$ can be computed by averaging across all motion states from a specific bin/group (Fig. 4. In contrast to Eq. 5, the MP NuFT approach involves separate $\mathrm{NuFT}_{\hat{k}_j}$ operators for each bin j, as illustrated in Eq. 7 below.

$$s = \begin{pmatrix}s_1\\s_2\\\vdots\\s_{N_j}\end{pmatrix} = \begin{pmatrix}\exp\left(i\hat{\phi}_{\hat{k}_1}\right)\mathrm{NuFT}_{\hat{k}_1} C_1 x\\\exp\left(i\hat{\phi}_{\hat{k}_2}\right)\mathrm{NuFT}_{\hat{k}_2} C_2 x\\\vdots\\\exp\left(i\hat{\phi}_{\hat{k}_{N_j}}\right)\mathrm{NuFT}_{\hat{k}_{N_j}} C_{N_j} x\end{pmatrix} \tag{7}$$

The motion mitigated image is again obtained by solving Eq. 2. Since this approach involves different NuFT operators for each group of motion state, it is also referred to as multi-pose NuFT.

An alternative multi-pose NuFT approach involves a pre-rotation of the image x. This may be written mathematically as shown in Eq. 8:

$$x_j = R_{\theta_j} T_{\theta_j} x \tag{8}$$

In this approach, it is necessary to adapt the k-space coordinates k1 to correct for the difference motion between the true motion states and the NuFT group motion state, as written below in Eq. 9.

$$s = \begin{pmatrix} s_1 \\ s_2 \\ \vdots \\ s_{N_j} \end{pmatrix} = \begin{pmatrix} \exp\left(i\hat{\phi}_{\hat{k}_1}\right) \mathrm{NuFT}_{\hat{k}_1} C x_1 \\ \exp\left(i\hat{\phi}_{\hat{k}_2}\right) \mathrm{NuFT}_{\hat{k}_2} C x_2 \\ \vdots \\ \exp\left(i\hat{\phi}_{\hat{k}_{N_j}}\right) \mathrm{NuFT}_{\hat{k}_{N_j}} C x_{N_j} \end{pmatrix} \tag{9}$$

The motion mitigated image is again obtained by solving Eq. 2.

The invention thus proposes a generalized multi-pose NuFT, wherein arbitrary image transformations of both the image and coil sensitivity are allowed, based on a small number of NuFT groups / group_motion states. The NuFT k-space coordinates need to be adjusted correct for the remaining/relative motion that has not been accounted for.

It has been shown that proposed MP NuFT forward model mitigates residual artifacts leading to comparable image quality as the standard SENSE+motion model, with considerably reduced computation time.

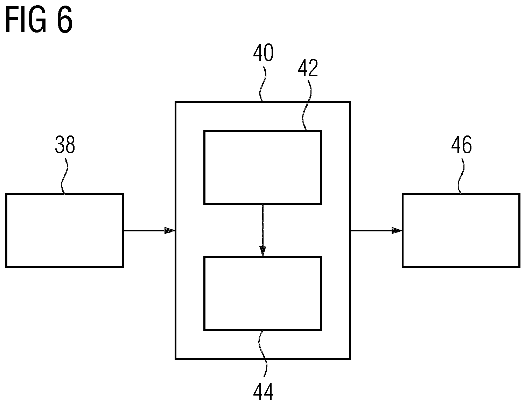

Fig. 6 shows a flow diagram of a method for reconstructing a motion-corrected magnetic resonance image of a subject according to an embodiment of the invention. In a first step 38, the motion trajectory is clustered into $N_j$. bins, as described above. The next step 40 is repeated for every bin j. First, in step 42, inverse-rotated coil sensitivity maps $C_j$ are calculated according to equation 6 for each group motion state. In the next step 44, the synthetic k-space is computed for each bin according to equation 7 above. Finally, in step 46, the complete synthetic k-space is computed and the model is solved to obtain the motion corrected image according to equation 2.

**Claims**

1. A computer-implemented method for reconstructing a motion-corrected magnetic resonance image (20) of a subject, comprising:

   a. receiving k-space magnetic resonance image data acquired of the subject (U) using a multi-channel coil array (7.1, 7.2) during a magnetic resonance imaging acquisition;
   b. receiving coil sensitivity maps (24) of the multi-channel coil array;
   c. receiving a motion trajectory comprising a series of motion states which were held by the subject during the acquisition;
   d. determining similarities across the motion states and forming groups of motion states (G1, G2, G3), such that each group contains motion states that are similar to each other, and determining a single group motion state representing each group;
   e. for each group of motion states, computing a single transformation operator and building a group-specific NuFT forward model, in which a mismatch between the coil sensitivity maps (24) and the magnetic resonance image (20) caused by a motion (20) of the subject during the acquisition is reduced by operating the transformation operator on the coil sensitivity maps (24) and/or on the magnetic resonance image (22),
   f. reconstructing (46) the motion-corrected magnetic resonance image by minimizing the data consistency error between the received k-space data and the group-specific NuFT forward models, wherein each NuFT forward model comprises an image estimate, the coil sensitivity maps, a non-uniform Fourier Transformation (30), and a phase factor corresponding to the motion state held by the subject at the time of acquiring the corresponding subset of k-space data.

2. The method of claim 1, wherein the transformation operator is computed on the basis of the group motion state, wherein the transformation operator in particular corresponds to the group motion state.

3. The method according to claim 1 or 2, wherein the method comprises

- for each group (G1, G2, G3) of motion states, determining the part of the k-space data that was acquired while the subject was in one of the motion states belonging to that group, and
- dividing the k-space data into bins according to their group of motion states, wherein the k-space data from each bin is processed using a group-specific non-uniform Fourier Transformation operator during the reconstruction of the motion-corrected magnetic resonance image.

4. The method according to any one of the preceding claims, comprising a step of calculating a transformation operator, which preferably represents the motion of the group motion state, and computing inverse-rotated coil sensitivity maps by operating the inverse of the transformation operator (22) on the coil sensitivity maps (24).

5. The method according to claim 4, wherein the inverse-rotated coil sensitivity maps are calculated according to

$$C_j = \left( R_{\theta_j} T_{\theta_j} \right)^{-1} C$$

wherein C represents the coil sensitivity maps (24), j is the number of the group of motion states (G1, G2, G3), $\theta_j$ is the transformation operator belonging to that group, $R_{\theta_j}$ is the rotation matrix belonging to the transformation operator $\theta_j$, $T_{\theta_j}$ is the translation vector belonging to the transformation operator $\theta_j$, and $C_j$ represents the inverse-rotated coil sensitivity maps for group j.

6. The method according to one of the preceding claims, wherein step (e) comprises operating the transformation operator onto the magnetic resonance image, where by the image is pre-rotated and/or pre-shifted (22).

7. The method of claim 6, wherein step (e) comprises operating the transformation operator onto the magnetic resonance image according to

$$x_j = R_{\theta_j} T_{\theta_j} x$$

wherein x is the magnetic resonance image (20), j is the index of the group of motion states, $\theta_j$ is the transformation operator belonging to that group, $R_{\theta_j}$ is the rotation matrix belonging to the transformation operator $\theta_j$, $T_{\theta_j}$ is the translation vector belonging to the transformation operator $\theta_j$, and $x_j$ is the pre-rotated and/or pre-shifted image for group j.

8. The method of one of the preceding claims, wherein the non-uniform Fourier Transformation (30) uses calculated k-space coordinates, wherein the calculated k-space coordinates are derived by transforming the original k-space coordinates of each subset of k-space data with a rotational operator corresponding to the motion state held by the subject at the time of acquiring the corresponding subset of k-space data, wherein the motion states are optionally corrected by the transformation operator, if the transformation operator is operated onto the magnetic resonance image, whereby the image is pre-rotated and/or pre-shifted.

9. The method of one of the preceding claims ,
wherein the motion trajectory is determined by using any one of

- a retrospective motion correction method,
- a motion tracking device, in particular a radiofrequency pick-up coil or an optical camera,
- a navigator method,
- an AI-based motion detection method, or
- a Pilot Tone method.

10. The method according to any one of the preceding claims,
wherein each motion state comprises a plurality of motion parameters, in particular translational and rotational motion parameters, and wherein a group of motion states (G1, G2, G3) are categorized to be similar to each other if all motion parameters of any one of the group of motion states differ by no more than by a predetermined threshold value from the corresponding motion parameter of any other one of the group of motion states.

11. The method according to any one of the preceding claims, wherein the motion trajectory comprises one motion state per subset of k-space data, wherein a subset corresponds in particular to one shot of acquired k-space data.

12. The method according to any one of the preceding claims, comprising a further step performed after step (d) of

- assessing the number of groups of motion states (G1, G2, G3),
- selecting the image reconstruction process according to the number of groups of motion states to comprise either steps (e) and (f), or to comprise an image reconstruction process using the SENSE + motion model wherein the groups of motion states are combined to reduce the reconstruction time.

13. A computer program comprising instructions, which, when the program is executed by a data processing device (15), cause the data processing device to carry out the method of any one of the preceding claims.

14. A data processing device (15) comprising means for carrying out the method of any one of claims 1 to 12.

15. A magnetic resonance apparatus (1) comprising a data processing device (15) according to claim 14.

## FIG 1

FIG 2

20  22

24  26  28

FIG 3

SENSE+
motion

20  22  24  26  28

SENSE+
motion

20  24  22  26  28

NuFT

20  24  30

## FIG 4

## FIG 5

FIG 6

**EUROPEAN SEARCH REPORT**

Application Number

EP 24 20 8884

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | AHSAN JAVED ET AL: "Improved 3D stack-of-spiral UTE pulmonary imaging at 0.55T using iterative concomitant field and motion corrected reconstruction (iCoMoCo)", PROCEEDINGS OF THE JOINT ANNUAL MEETING ISMRM-ESMRMB 2022 & ISMRT ANNUAL MEETING, LONDON, UK, 07-12 MAY 2022, ISMRM, 2030 ADDISON STREET, 7TH FLOOR, BERKELEY, CA 94704 USA, no. 1397, 22 April 2022 (2022-04-22), XP040727945, * the whole document * | 1-15 | INV. G01R33/565 G01R33/561 |
| A | BAMMER R ET AL: "Augmented generalized SENSE reconstruction to correct for rigid body motion", MAGNETIC RESONANCE IN MEDICINE, WILEY-LISS, US, vol. 57, 26 December 2006 (2006-12-26), pages 90-102, XP002482845, ISSN: 0740-3194, DOI: 10.1002/MRM.21106 * the whole document * | 1-15 | |
| | | | **TECHNICAL FIELDS SEARCHED (IPC)** G01R |

The present search report has been drawn up for all claims

| Place of search | Date of completion of the search | Examiner |
|---|---|---|
| Munich | 12 March 2025 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 4187271 A1

### Non-patent literature cited in the description

- **J. HAMILTON** ; **D. FRANSON** ; **N. SEIBERLICH**. Recent Advances in Parallel Imaging for MRI. *Prog. Nucl. Magn. Reson. Spectrosc.*, 2017, vol. 101, 71-95
- **L. CORDERO-GRANDE** ; **E. J. HUGHES** ; **J. HUTTER** ; **A. N. PRICE** ; **J. V HAJNAL**. Three-dimensional motion corrected sensitivity encoding reconstruction for multi-shot multi-slice MRI: Application to neonatal brain imaging. *Magn. Reson. Med.*, 2018, vol. 79 (3), 1365-1376
- **L. CORDERO-GRANDE** ; **R. TEIXEIRA** ; **E. HUGHES** ; **J. HUTTER** ; **A. PRICE, HAJNAL**. Sensitivity Encoding for Aligned Multishot Magnetic Resonance Reconstruction. *IEEE Trans. Comput. Imaging*, 2016, vol. 2 (3), 266-280
- **M. W. HASKELL** ; **S. F. CAULEY** ; **L. L. WALD**. TArgeted Motion Estimation and Reduction (TAMER): Data consistency based motion mitigation for MRI using a reduced model joint optimization. *IEEE Trans. Med. Imaging*, 2018, vol. 37 (5), 1253-1265
- **D. POLAK** ; **D. N. SPLITTHOFF** ; **B. CLIFFORD** ; **W.-C. LO** ; **S. HUANG** ; **J. CONKLIN** ; **L. L. WALD** ; **K. SETSOMPOP** ; **S. CAULEY**. Scout accelerated motion estimation and reduction (SAMER). *Magn. Reson. Med.*, 2022, vol. 87, 163-178, https://doi.org/10.1002/mrm.28971
- **D. POLAK** ; **J. HOSSBACH** ; **D. N. SPLITTHOFF et al.** Motion guidance lines for robust data consistency-based retrospective motion correction in 2D and 3D MRI. *Magn. Reson. Med.*, 2023, 1-14
- **FESSLER J** ; **SUTTON B**. Nonuniform fast Fourier transforms using min-max interpolation. *IEEE Trans Signal Process*, 2003, vol. 51, 560-574
- **PRUESSMANN K.P. et al.** Advances in sensitivity encoding with arbitrary k-space trajectories. *Magn Reson Med.*, 2001, vol. 46 (4), 638-651
- **BATCHELOR P.G. et al.** Matrix description of general motion correction applied to multishot images. *Magn Reson Med.*, 2005, vol. 54 (5), 1273-1280